# EUROPEAN PATENT APPLICATION

(11) **EP 2 535 944 A1**
(43) Date of publication of application: **19.12.2012**
(21) Application number: 11742067.9
(22) Date of filing: 11.01.2011
(51) Int. Cl.: H01L 31/042

(54) **SOLAR CELL STRING, SOLAR CELL MODULE, AND SOLAR CELL**

(30) Priority: 09.02.2010 JP 2010026111
(71) Applicant: Sharp Kabushiki Kaisha, Osaka-shi, Osaka 545-8522 (JP)
(72) Inventor: SAWADA, Kohei, Osaka 545-8522 (JP); MIKAMI, Rui, Osaka 545-8522 (JP)
(74) Representative: Müller - Hoffmann & Partner
(86) International application number: PCT/JP2011/050234
(87) International publication number: WO 2011/099318

(57) **Abstract**

A solar battery string is provided that suppresses a lowering in the mounting density of solar battery cells, that can shorten manufacturing time, and that can prevent solar battery cells from being destroyed. The solar battery string (1) has a plurality of solar battery cells (2) and a circuit board (3). The solar battery cells (2) have a semiconductor substrate (10), which has an n-type conductivity region (10c) and, formed on the reverse face (10b) side of the semiconductor substrate, an n⁺-type conductivity region (10d) and p-type conductivity regions (10e and 10f). The circuit board electrically connects the n⁺-type conductivity region of a solar battery cell (2a) to the p-type conductivity regions (10e) of a solar battery cell (2b), and electrically connects the p-type conductivity regions (10f) of the solar battery cell (2a) to the n⁺-type conductivity region (10d) of the solar battery cell (2b).

## Description

### Technical Field

The present invention relates to solar battery strings, solar battery modules, and solar battery cells.

### Background Art

Against the trend of rising interests in global environmental issues, solar batteries, which convert light energy into electric energy, have been receiving increasing attention as an environmentally-friendly, clean energy source.

Among the variety of materials, including compound semiconductor materials and organic materials, that are used in solar batteries, those employing crystalline silicon are today the mainstream.

Typically, a solar battery cell alone is rarely used as s solar battery; a plurality of solar battery cells are connected in series and/or in parallel to yield the desired output, so as thereby to form a solar battery string. The solar battery string is then sealed in a sealing member for use as a solar battery module.

Inconveniently, however, when any of the solar battery cells is shaded during the use of the solar battery module for some reason, the voltage generated in the other solar battery cells is applied as a reverse bias voltage to the shaded solar battery cell. If the reverse bias voltage exceeds the breakdown voltage of the shaded solar battery cell, this cell breaks down and is short-circuited, resulting in a lowering in the output of the solar battery module as a whole.

To prevent breakdown caused by a reverse bias voltage, therefore, many different structures have been proposed (see, for example, Patent Documents 1 and 2 listed below).

Patent Document 1 mentioned above discloses a solar battery module which is provided with a plurality of solar battery cells connected in series and a plurality of bypass diodes.

In this solar battery module, an electrode on the light-receiving face side of a solar battery cell is connected, via a lead or the like, to an electrode on a reverse face side of the solar battery cell adjacent at one side. On the other hand, an electrode on the reverse face side of a solar battery cell is connected, via a lead or the like, to an electrode on a light-receiving face side of the solar battery cell adjacent at the other side. In this way the plurality of solar battery cells are connected in series.

Moreover, in this solar battery module, the bypass diodes are externally connected in parallel with the solar battery cells on a one-for-one basis. Thus, in this solar battery module, when any of the solar battery cells is shaded for some reason, electric current can be bypassed so that no electric current passes through the shaded solar battery cell. Thus, it is possible to prevent the shaded solar battery cell from being destroyed by a reverse bias voltage.

Patent Document 2 mentioned above discloses a solar battery cell in which a pn junction for photoelectric conversion and a pn junction as a bypass connected in parallel with it are formed integrally.

In this solar battery cell, in a light-receiving face of a p-type silicon substrate, an n⁺-type diffusion layer is formed, so that the p-type silicon substrate and the n⁺-type diffusion layer together form the pn junction for photoelectric conversion. Moreover, in a partial region in the reverse face of the p-type silicon substrate, an n-type diffusion region is formed, and in part of the reverse face of the n-type diffusion region, a p-type diffusion layer is formed, so that the n-type diffusion region and the p-type diffusion layer together form the pn junction as a bypass.

Furthermore, on the light-receiving face of the p-type silicon substrate, an obverse-side electrode is formed which is electrically connected to the n⁺-type diffusion layer, and on the reverse face of the p-type silicon substrate, a reverse-side electrode is formed which is electrically connected to the p-type silicon substrate. Moreover, part of the obverse-side electrode is formed so as to pass across a lateral face of the p-type silicon substrate and reach the reverse face, and is electrically connected to the p-type diffusion layer. Furthermore, on the lateral face of the p-type silicon substrate etc., an oxide film is formed to prevent short-circuiting between the obverse-side electrode and the p-type silicon substrate or the n-type diffusion region.

According to Patent Document 2 mentioned above, part of the obverse-side electrode is formed so as to reach the reverse face, and thus adjacent solar battery cells can be connected tougher on the reverse face side alone.

Moreover, according to Patent Document 2 mentioned above, owing to the pn junction as a bypass being connected in parallel with the pn junction for photoelectric conversion, as according to Patent Document 1 mentioned above, when any of the solar battery cells is shaded for some reason, electric current can be bypassed so that no electric current passes through the shaded solar battery cell. Thus, it is possible to prevent the shaded solar battery cell from being destroyed by a reverse bias voltage.

### List of Citations

### Patent Literature

Patent Document 1: JP-A-H05-152596 (Fig. 1)
Patent Document 2: JP-A-H03-024768 (Page 4, Fig. 5)

### Summary of Invention

### Technical Problem

The conventional technologies cited above, however, have the following disadvantages. According to Patent Document 1 mentioned above, the bypass diodes are externally connected to the solar battery cells on a one-for-one basis, and thus it is necessary to fit as many diodes as there are solar battery cells. This prolongs the time required to manufacture the solar battery module, and lowers the mounting density of the solar battery cells in the solar battery module.

Moreover, according to Patent Document 1 mentioned above, when adjacent solar battery cells are electrically connected together to build the solar battery module, wiring needs to be done with the electrodes on both the light-receiving face side and the reverse face side of the solar battery cells. This complicates the structure of the solar battery module, and further prolongs the manufacturing time. Furthermore, between adjacent solar battery cells, a gap needs to be provided to pass a lead or the like through. This lowers the mounting density of the solar battery cells in the solar battery module.

On the other hand, according to Patent Document 2, the oxide film is formed on the lateral face of the p-type silicon substrate etc., and part of the obverse-side electrode is formed so as to reach the reverse face. This prolongs the time required to manufacture the solar battery cell.

Moreover, according to Patent Document 2, the p-type silicon substrate and the n⁺-type diffusion layer together form the pn junction for photoelectric conversion, and the n-type diffusion region and the p-type diffusion layer together form the pn junction as a bypass. That is, the pn junction for photoelectric conversion and the pn junction as a bypass are formed separately. This further prolongs the time required to manufacture the solar battery cell.

Devised to overcome the inconveniences and disadvantages discussed above, the present invention aims to provide a solar battery string, a solar battery module, and a solar battery cell that can prevent a lowering in the mounting density of solar battery cells, that can reduce the manufacturing time, and that can prevent destruction of solar battery cells.

### Solution to Problem

To achieve the above object, according to a first aspect of the invention, a solar battery string is provided with: a plurality of solar battery cells; and a connecting member which electrically connects together the plurality of solar battery cells. Here, the solar battery cells each include: a semiconductor substrate which has a first region of a first conductivity type; a second region of a second conductivity type which is provided in the reverse face of the semiconductor substrate and which contains a higher concentration of a dopant than the first region; and third and fourth regions of a second conductivity type which are provided in the reverse face of the semiconductor substrate. The plurality of solar battery cells include first and second solar battery cells which are electrically connected together, and the connecting member includes: a first connecting portion which electrically connects together the second region of the first solar battery cell and the third region of the second solar battery cell; and a second connecting portion which electrically connects together the fourth region of the first solar battery cell and the second region of the second solar battery cell.

In this solar battery string according to the first aspect, the fourth and first regions can together form a diode. Moreover, owing to, as described above, the connecting member including the first connecting portion which electrically connects together the second region of the first solar battery cell and the third region of the second solar battery cell and the second connecting portion which electrically connects together the fourth region of the first solar battery cell and the second region of the second solar battery cell, the second region of the first solar battery cell and the third region of the second solar battery cell can be electrically connected together, and the fourth region of the first solar battery cell and the second region of the second solar battery can be electrically connected together. Thus, the above-mentioned diode of the first solar battery cell can be connected in parallel with the second solar battery cell, so that this diode functions as a bypass diode. Thus, when the second solar battery cell is shaded for some reason, electric current can be bypassed so that no electric current passes through the second solar battery cell, and thus it is possible to prevent the second solar battery cell from being destroyed by a reverse bias voltage.

As described above, in the solar battery string according to the first aspect, there is no need to externally connect a bypass diode to every solar battery cell. Thus, compared with a case where a bypass diode is externally connected to every solar battery cell, it is possible to shorten the manufacturing time of the solar battery string, and to suppress a lowering in the mounting density of solar battery cells in the solar battery string.

Moreover, in the solar battery string according to the first aspect, the first region of a first conductivity type and the third region of a second conductivity type together form a diode that generates electric power when irradiated by solar light. Moreover, as described above, the fourth and first regions together form a bypass diode. That is, the first region can be shared between the diode that generates electric power when irradiated by solar light and the bypass diode. Thus, compared with a case where a diode that generates electric power when irradiated by solar light and a bypass diode are formed separately, it is possible to shorten the manufacturing time of the solar battery cells.

Moreover, in the solar battery string according to the first aspect, owing to, as described above, the second, third, and fourth regions being provided in the reverse face of the semiconductor substrate, wiring can be done on the reverse face side of the semiconductor substrate alone. Thus, it is possible to simplify the structure, and to further reduce the manufacturing time.

Moreover, since wiring can be done on the reverse face side of the semiconductor substrate alone, there is no need to provide a gap between adjacent solar battery cells to pass a lead or the like through. Thus, it is possible to further reduce a lowering in the mounting density of solar battery cells.

Moreover, owing to the second, third, and fourth regions being formed in the reverse face of the semiconductor substrate, there is no need to provide an electrode on the light-receiving face of the semiconductor substrate and form part of the electrode to reach the reverse face. Thus, it is possible to further reduce the time required to manufacture the solar battery cells.

Moreover, in the solar battery string according to the first aspect, since there is no need to provide an electrode or the like on the light-receiving face of the solar battery cells, it is possible to suppress a lessening of the light-receiving area of the solar battery cells. Thus, it is possible to suppress a lowering in the power generation efficiency.

In the above-described solar battery string according to the first aspect, preferably, the connecting member includes: a base which is electrically insulating; and the first and second connecting portions which are formed of a conductor layer formed on the obverse face of the base. With this structure, by use of the connecting member, the first and second solar battery cells can easily be electrically connected together. Moreover, by use of the connecting member described above, after a plurality of solar battery cells are mounted on the connecting member, for example through a reflow process, the plurality of solar battery cells and the connecting member can be electrically connected together at once. This makes it easy to manufacture the solar battery string, and helps further shorten the manufacturing time.

In the above-described solar battery string according to the first aspect, preferably, the solar battery cells include a light-shielding portion which is formed on the light-receiving face of the semiconductor substrate and which covers the light-receiving face side of the fourth region. With this structure, it is possible to prevent the fourth region from being irradiated by solar light. It is thus possible to suppress a power loss resulting from the diode (bypass diode) formed by the fourth and first regions generating electric power, and thus to suppress a lowering in the power generation efficiency of the solar battery cells.

In the above-described solar battery string according to the first aspect, preferably, the fourth region is provided near an end of the reverse face of the semiconductor substrate. With this structure, it is easy to prevent the first and second connecting portions of the connecting member from crossing each other. That is, it is possible to prevent complicated wiring with the first and second connecting portions.

In the above-described solar battery string according to the first aspect, preferably, the solar battery cells each has a plurality of fourth regions. With this structure, it is possible to disperse the heat generated when electric current passes through the diode (bypass diode) formed by the fourth and first regions. It is thus possible to prevent the solar battery cells from becoming hot, and thus to suppress a lowering in the power generation efficiency of the solar battery cells.

In the above-described solar battery string according to the first aspect, the second region may be arranged between the third and fourth regions.

In the above-described solar battery string according to the first aspect, preferably, first, second, and third electrodes are provided on the second, third, and fourth regions respectively. With this structure, it is easy to electrically connect the second, third, and fourth regions of the solar battery cells to the connecting member.

In the above-described solar battery string according to the first aspect, preferably, the connecting member is provided with a bypass diode on a one-for-one basis, and the bypass diode is connected in parallel with the first solar battery cell. With this structure, a bypass diode (which may be the diode formed by the fourth and first regions) can be connected in parallel with every solar battery cell. Thus, even when any of the solar battery cells is shaded, it is possible to prevent it from being destroyed.

According to a second aspect of the invention, a solar battery module is provided with: a solar battery string structured as described above; and a sealing member which seals the solar battery string. With this structure, it is possible to realize a solar battery module that can suppress a lowering in the mounting density of solar battery cells, that can shorten the manufacturing time, and that can prevent solar battery cells from being destroyed.

According to a third aspect of the invention, a solar battery cell is provided with: a semiconductor substrate which has a first region of a first conductivity type; a second region of a second conductivity type which is provided in the reverse face of the semiconductor substrate and which contains a higher concentration of a dopant than the first region; and third and fourth regions of a second conductivity type which are provided in the reverse face of the semiconductor substrate.

In this solar battery cell according to the third aspect, the fourth and first regions can together form a diode. Moreover, when a plurality of solar battery cells are assembled into a solar battery string, by electrically connecting together the second region of the first solar battery cell among the plurality of solar battery cells and the third region of the second solar battery cell among the plurality of solar battery cells and electrically connecting together the fourth region of the first solar battery cell and the second region of the second solar battery cell, the above-mentioned diode of the first solar battery cell can be connected in parallel with the second solar battery cell, so that this diode functions as a bypass diode. Thus, when the second solar battery cell is shaded for some reason, electric current can be bypassed so that no electric current passes through the second solar battery cell, and thus it is possible to prevent the second solar battery cell from being destroyed by a reverse bias voltage.

Thus, by use of the solar battery cell according to the third aspect, when a plurality of solar battery cells are assembled into a solar battery string, there is no need to externally connect a bypass diode to every solar battery cell. Thus, compared with a case where a bypass diode is externally connected to every solar battery cell, it is possible to shorten the manufacturing time of the solar battery string, and to suppress a lowering in the mounting density of solar battery cells in the solar battery string.

Moreover, in the solar battery cell according to the third aspect, the first region of a first conductivity type and the third region of a second conductivity type together form a diode that generates electric power when irradiated by solar light. Moreover, as described above, the fourth and first regions together form a bypass diode. That is, the first region can be shared between the diode that generates electric power when irradiated by solar light and the bypass diode. Thus, compared with a case where a diode that generates electric power when irradiated by solar light and a bypass diode are formed separately, it is possible to shorten the manufacturing time of the solar battery cells.

Moreover, in the solar battery cell according to the third aspect, as described above, the second, third, and fourth regions are provided in the reverse face of the semiconductor substrate. Thus, when a plurality of solar battery cells are assembled into a solar battery string, wiring can be done on the reverse face side of the semiconductor substrate alone. Thus, it is possible to simplify the structure of the solar battery string, and to further reduce the manufacturing time.

Moreover, when a plurality of solar battery cells are assembled into a solar battery string, since wiring can be done on the reverse face side of the semiconductor substrate alone, there is no need to provide a gap between adjacent solar battery cells to pass a lead or the like through. Thus, it is possible to further reduce a lowering in the mounting density of solar battery cells.

Moreover, owing to the second, third, and fourth regions being formed in the reverse face of the semiconductor substrate, there is no need to provide an electrode on the light-receiving face of the semiconductor substrate and form part of the electrode to reach the reverse face. Thus, it is possible to further reduce the time required to manufacture the solar battery cells.

Moreover, in the solar battery cell according to the third aspect, since there is no need to provide an electrode or the like on the light-receiving face of the solar battery cells, it is possible to suppress a lessening of the light-receiving area of the solar battery cells. Thus, it is possible to suppress a lowering in the power generation efficiency.

In the solar battery cell according to the third aspect, preferably, there is further provided a light-shielding portion which is provided on the light-receiving face of the semiconductor substrate and which covers the light-receiving face side of the fourth region. With this structure, it is possible to prevent the fourth region from being irradiated by solar light. It is thus possible to suppress a power loss resulting from the diode (bypass diode) formed by the fourth and first regions generating electric power, and thus to suppress a lowering in the power generation efficiency of the solar battery cells.

### Advantageous Effects of the Invention

As described above, according to the present invention, it is easy to realize a solar battery string that can prevent a lowering in the mounting density of solar battery cells, that can reduce the manufacturing time, and that can prevent destruction of solar battery cells, and a solar battery module incorporating it.

### Brief Description of Drawings

[Fig. 1] is a plan view showing the structure of a solar battery string embodying the invention;
[Fig. 2] is a sectional view along line 100-100 in Fig. 1;
[Fig. 3] is a sectional view along line 150-150 in Fig. 1;
[Fig. 4] is a plan view showing the structure of a solar battery cell in the solar battery string embodying the invention shown in Fig. 1;
[Fig. 5] is a bottom view showing the structure of a solar battery cell in the solar battery string embodying the invention shown in Fig. 1;
[Fig. 6] is a sectional view along line 200-200 in Fig. 4;
[Fig. 7] is a sectional view along line 250-250 in Fig. 4;
[Fig. 8] is a plan view showing the structure of a circuit board in the solar battery string embodying the invention shown in Fig. 1;
[Fig. 9] is a diagram showing an equivalent circuit of the solar battery string embodying the invention shown in Fig. 1;
[Fig. 10] is a diagram illustrating the operation of the solar battery string embodying the invention shown in Fig. 1;
[Fig. 11] is a diagram illustrating the operation of the solar battery string embodying the invention shown in Fig. 1;
[Fig. 12] is a sectional view illustrating the manufacturing process of a solar battery cell in the solar battery string embodying the invention shown in Fig. 1;
[Fig. 13] is a sectional view illustrating the manufacturing process of a solar battery cell in the solar battery string embodying the invention shown in Fig. 1;
[Fig. 14] is a sectional view illustrating the manufacturing process of a solar battery cell in the solar battery string embodying the invention shown in Fig. 1;
[Fig. 15] is a sectional view illustrating the manufacturing process of a solar battery cell in the solar battery string embodying the invention shown in Fig. 1;
[Fig. 16] is a sectional view illustrating the manufacturing process of a solar battery cell in the solar battery string embodying the invention shown in Fig. 1;
[Fig. 17] is a sectional view illustrating the manufacturing process of a solar battery cell in the solar battery string embodying the invention shown in Fig. 1;
[Fig. 18] is a sectional view illustrating the manufacturing process of a solar battery cell in the solar battery string embodying the invention shown in Fig. 1;
[Fig. 19] is a sectional view illustrating the manufacturing process of a solar battery cell in the solar battery string embodying the invention shown in Fig. 1;
[Fig. 20] is a sectional view illustrating the manufacturing process of a solar battery cell in the solar battery string embodying the invention shown in Fig. 1;
[Fig. 21] is a sectional view illustrating the manufacturing process of a solar battery cell in the solar battery string embodying the invention shown in Fig. 1;
[Fig. 22] is a sectional view illustrating the manufacturing process of a solar battery cell in the solar battery string embodying the invention shown in Fig. 1;
[Fig. 23] is a sectional view showing the structure of a solar battery module incorporating the solar battery string embodying the invention shown in Fig. 1; and
[Fig. 24] is a sectional view illustrating the manufacturing process of a solar battery module incorporating the solar battery string embodying the invention shown in Fig. 1.

### Description of Embodiments

An embodiment of a present invention will be described below with reference to the accompanying drawings.

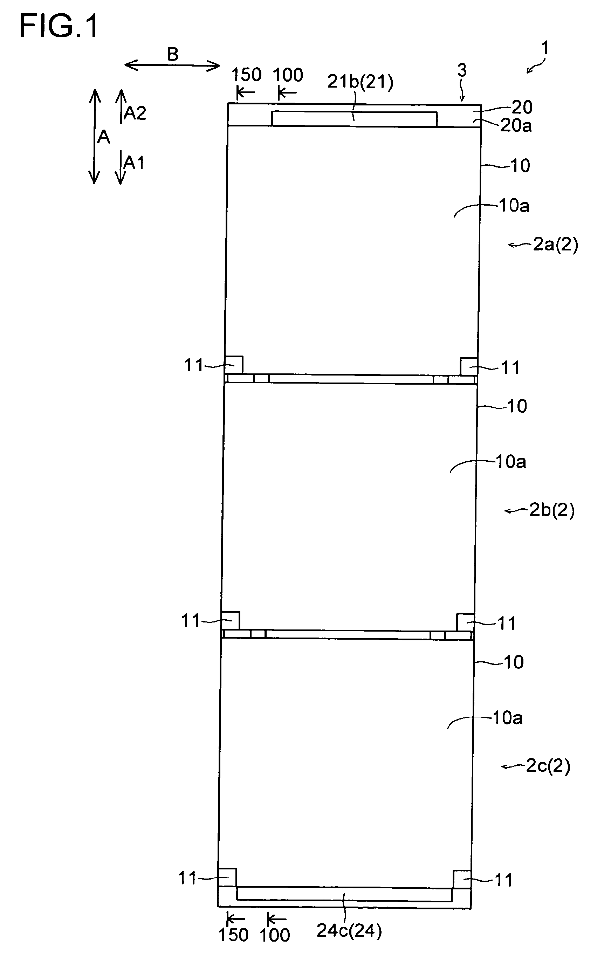

First, with reference to Figs. 1 to 9, the structure of a solar battery string 1 embodying the invention will be described. For easy understanding, hatching is occasionally applied even in a plan or bottom view.

As shown in Figs. 1 to 3, the solar battery string 1 embodying the invention is provided with a plurality of solar battery cells 2 and a circuit board 3 which electrically connect the plurality of solar battery cells in series. The circuit board 3 is an example of a "connecting member" according to the invention.

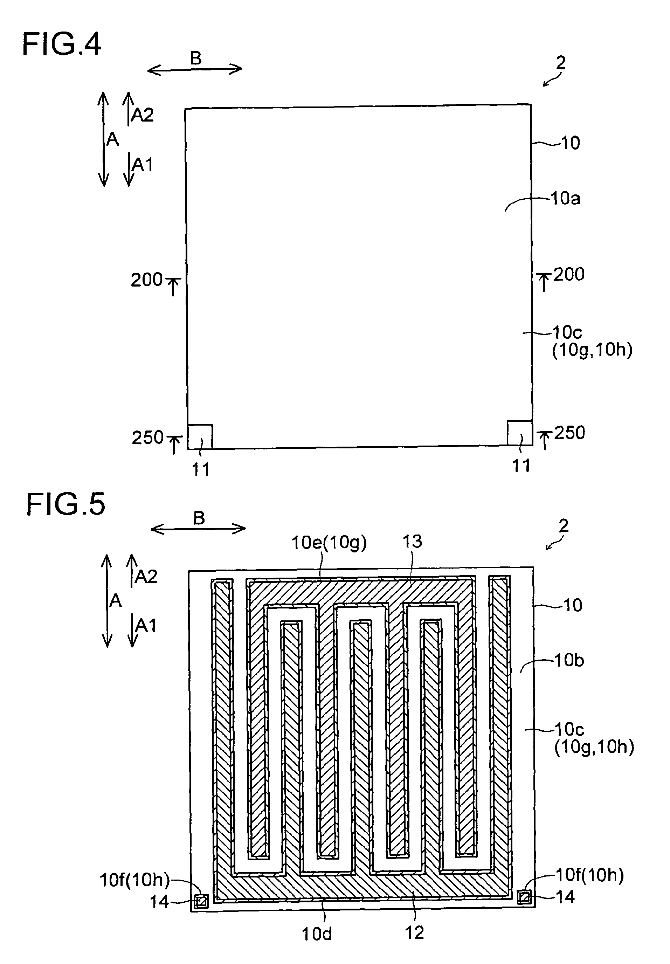

As shown in Figs. 4 to 7, each solar battery cell 2 includes: a semiconductor substrate 10; a light-shielding film 11 which is provided on the light-receiving face 10a of the semiconductor substrate 10; and an n-electrode 12 and p-electrodes 13 and 14 which are provided on the reverse face 10b of the semiconductor substrate 10. The light-shielding film 11 is an example of a "light-shielding portion" according to the invention, and the n-electrode 12 is an example of a "first electrode" according to the invention. The p-electrode 13 is an example of a "second electrode" according to the invention, and the p-electrode 14 is an example of a "third electrode" according to the invention.

The semiconductor substrate 10 is formed of an n-type silicon substrate, and is formed to have a thickness of about 50 µm to about 400 µm. It is preferable that, on the light-receiving face 10a of the semiconductor substrate 10, a texture structure (not shown) be formed, and that, on the light-receiving face 10a of the semiconductor substrate 10, an anti-reflection film (not shown) be arranged. With this structure, it is possible to prevent solar light from being reflected on the light-receiving face 10a of the semiconductor substrate 10.

Here, in this embodiment, the semiconductor substrate 10 includes: an n-type conductivity region 10c; an n⁺-type conductivity region 10d provided on the reverse face 10b side of the semiconductor substrate 10 and containing a higher concentration of a dopant than the n-type conductivity region 10c; and p-type conductivity regions 10e and 10f provided on the reverse face 10b side of the semiconductor substrate 10. The n-type conductivity region 10c and the p-type conductivity region 10e are joined together to form a pn junction; thus the n-type conductivity region 10c and the p-type conductivity region 10e together form a diode 10g which generates electric power when irradiated by solar light. The n-type conductivity region 10c, the n⁺-type conductivity region 10d, the p-type conductivity region 10e, and the p-type conductivity region 1 0f are an example of a "first region", a "second region", a "third region", and a "fourth region", respectively, according to the invention. The n and n⁺ types are examples of a "first conductivity type" according to the invention, and the p-type is an example of a "second conductivity type" according to the invention.

As shown in Fig. 5, the n⁺-type conductivity region 10d and the p-type conductivity region 10e are each formed in the shape of a comb. The n⁺-type conductivity region 10d and the p-type conductivity region 10e are arranged with their respective teeth facing each other so that their teeth mesh together to occur alternately.

As shown in Figs. 5 to 7, on the n⁺-type conductivity region 10d, the n-electrode 12 is formed which makes ohmic contact with the n⁺-type conductivity region 10d. Likewise, on the p-type conductivity region 10e, the p-electrode 13 is formed which makes ohmic contact with the p-type conductivity region 10e. Like the n⁺-type conductivity region 10d and the p-type conductivity region 10e, the n-electrode 12 and the p-electrode 13 also are each formed in the shape of a comb. And like the n⁺-type conductivity region 10d and the p-type conductivity region 10e, the n-electrode 12 and the p-electrode 13 also are arranged with their respective teeth facing each other so that their teeth mesh together to occur alternately.

The n⁺-type conductivity region 10d, the p-type conductivity region 10e, the n-electrode 12, and the p-electrode 13 are arranged so that their teeth extend in direction A (the direction in which the plurality of solar battery cells 2 (see Fig. 1) are arranged).

The p-type conductivity region 10f is provided near one end, in direction A (that is, in direction A1), of the reverse face 10b of the semiconductor substrate 10, near each of the opposite ends thereof in direction B (the direction perpendicular to direction A). That is, two of the p-type conductivity regions 1 0f are provided near the corners, in direction A1, of the reverse face 10b of the semiconductor substrate 10. The p-type conductivity region 10f and the n-type conductivity region 10c are joined together to form a pn junction, and as will be described later, the p-type conductivity region 1 0f and the n-type conductivity region 10c together form a bypass diode 10h.

On the p-type conductivity region 10f, the p-electrode 14 is formed which makes ohmic contact with the p-type conductivity region 1 0f.

The light-shielding film 11 is formed of a material that does not transmit light of wavelengths of about 300 nm or longer but about 1200 nm or shorter. The light-shielding film 11 can be formed of, for example, an electrically insulating base material such as of PET (polyethylene terephthalate), PEN (polyethylene naphthalate), polyimide, or ethylene-vinyl acetate, or a metal film such as of silver, copper, or aluminum. The material for the light-shielding film 11 is not limited to those just mentioned so long as it has a light-shielding property.

The light-shielding film 11 is provided near one end, in direction A (that is, in direction A1), of the light-receiving face 10a of the semiconductor substrate 10, near each of the opposite ends thereof in direction B. That is, two of the light-shielding films 11 are provided near the corners, in direction A1, of the light-receiving face 10a of the semiconductor substrate 10.

In this embodiment, the light-shielding film 11, as seen in a plan view, has a larger area than the p-type conductivity region 10f, and is arranged so as to cover the light-receiving face 10a side of the p-type conductivity region 10f. Specifically, the light-shielding film 11 is arranged so as to cover the light-receiving face 10a side of the p-type conductivity region 10f, the light-receiving face 10a side of the part of the n-type conductivity region 10c located near the p-type conductivity region 1 0f, and the light-receiving face 10a side of the part of the n⁺-type conductivity region 10d located near the p-type conductivity region 10f. In this structure, the part covered by the light-shielding film 11 is not irradiated by solar light, and thus the p-type conductivity region 10f and the n-type conductivity region 10c together form a diode (the bypass diode 10h) that does not contribute to the generation of electric power.

As shown in Figs. 1 to 3, the circuit board 3 is formed so that three solar battery cells 2 are mounted on it. Although the embodiment being discussed deals with a case where three solar battery cells 2 are mounted on the circuit board 3, two, or four or more, solar battery cells 2 may be mounted on the circuit board 3.

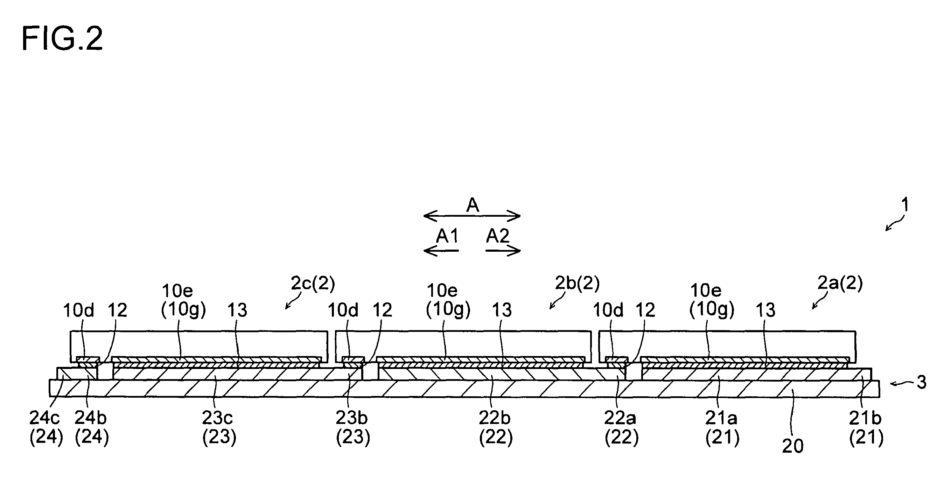

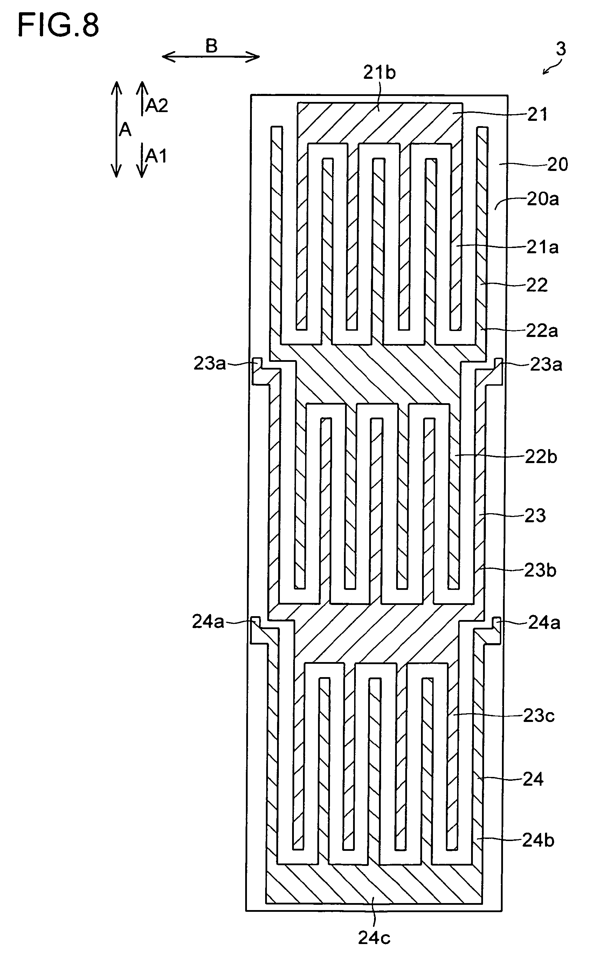

As shown in Figs. 2 and 8, the circuit board 3 is formed so as to extend in direction A. The circuit board 3 is composed of an electrically insulating base 20 formed to have a fixed thickness and electrode portions 21, 22, 23, and 24 which are parts of a metal conductor layer formed on one face 20a of the base 20. The electrode portions 21, 22, 23, and 24 are formed by patterning, as by etching, the metal conductor layer formed on the one face 20a of the base 20. Thus, the electrode portions 21, 22, 23, and 24 have their respective top faces formed at the same level. The one face 20a is an example of an "obverse face" according to the invention.

The base 20 can be formed of, for example, an electrically insulating base material such as of PET (polyethylene terephthalate), PEN (polyethylene naphthalate), polyimide, or ethylene-vinyl acetate. The material for the base 20, however, is not limited to those just mentioned so long as it has an electrically insulating property.

The electrode portions 21, 22, 23, and 24 can be formed of, for example, metal such as silver, copper, or aluminum. The material for the electrode portions 21, 22, 23, and 24 is not limited to those just mentioned so long as it has an electrically conductive property.

As shown in Figs. 5 and 8, the electrode portions 21, 22, 23, and 24 are formed in shapes corresponding to the n-electrode 12 and the p-electrodes 13 and 14 of the solar battery cells 2.

Specifically, the electrode portion 21 has a comb-shaped portion 21a corresponding to the p-electrode 13 of the solar battery cells 2 and an external connection terminal portion 21 b provided near the other end, in direction A (that is, in direction A2), of the base 20. The electrode portion 22 has a comb-shaped portion 22a corresponding to the n-electrode 12 of the solar battery cells 2 and a comb-shaped portion 22b corresponding to the p-electrode 13. The electrode portion 23 has a portion 23a corresponding to the p-electrode 14, a comb-shaped portion 23b corresponding to the n-electrode 12, and a comb-shaped portion 23c corresponding to the p-electrode 13. The electrode portion 24 has a portion 24a corresponding to the p-electrode 14, a comb-shaped portion 24b corresponding to the n-electrode 12, and an external connection terminal portion 24c provided near the end, in direction A1, of the base 20.

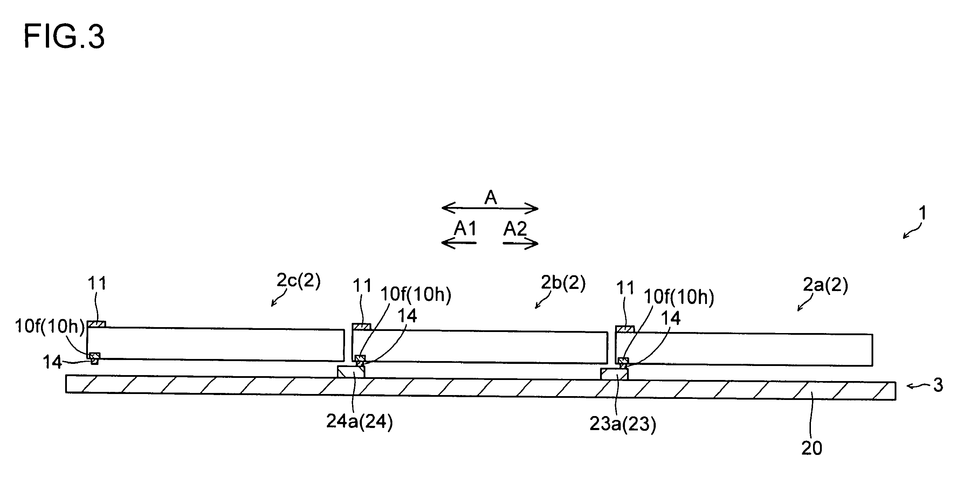

As shown in Figs. 2 and 3, of the three solar battery cells 2, the one 2a arranged farthest in direction A2 has its n-electrode 12 and p-electrodes 13 and 14 electrically connected to a portion 22a of the electrode portion 22, a portion 21 a of the electrode portion 21, and a portion 23a of the electrode portion 23 respectively.

Of the three solar battery cells 2, the one 2b arranged in the middle has its n-electrode 12 and p-electrodes 13 and 14 electrically connected to a portion 23b of the electrode portion 23, a portion 22b of the electrode portion 22, and a portion 24a of the electrode portion 24 respectively.

Of the three solar battery cells 2, the one 2c arranged farthest in direction A1 has its n-electrode 12 and p-electrode 13 electrically connected to a portion 24b of the electrode portion 24 and a portion 23c of the electrode portion 23 respectively. In this embodiment, the p-electrode 14 of the solar battery cell 2c is not electrically connected to the circuit board 3.

As a result of the three solar battery cells 2a, 2b, and 2c being electrically connected as described above on the circuit board 3, the n⁺-type conductivity region 10d of the solar battery cell 2a and the p-type conductivity region 10e of the solar battery cell 2b are electrically connected together via the electrode portion 22, and in addition the p-type conductivity region 10f of the solar battery cell 2a and the n⁺-type conductivity region 10d of the solar battery cell 2b are electrically connected together via the electrode portion 23. In this case, the solar battery cell 2a acts as a "first solar battery cell" according to the invention, and the solar battery cell 2b acts as the "second solar battery cell" according to the invention. The electrode portion 22 acts as a "first connecting portion" according to the invention, and the electrode portion 23 acts as a "second connecting portion" according to the invention.

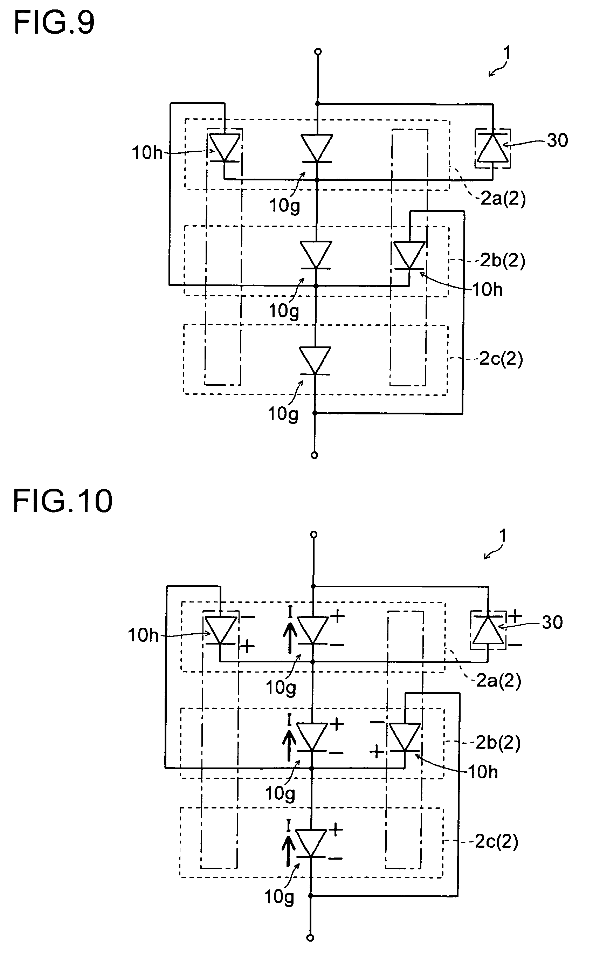

As shown in Fig. 9, the bypass diode 10h of the solar battery cell 2a is connected in parallel with the solar battery cell 2b. In Fig. 9, the regions enclosed by dash-and-dot lines are regions that are not irradiated by solar light.

Likewise, as shown in Figs. 2 and 3, the n⁺-type conductivity region 10d of the solar battery cell 2b and the p-type conductivity region 10e of the solar battery cell 2c are electrically connected together via the electrode portion 23, and in addition the p-type conductivity region 10f of the solar battery cell 2b and the n⁺-type conductivity region 10d of the solar battery cell 2c are electrically connected together via the electrode portion 24. In this case, the solar battery cell 2b acts as a "first solar battery cell" according to the invention, and the solar battery cell 2c acts as the "second solar battery cell" according to the invention. The electrode portion 23 acts as a "first connecting portion" according to the invention, and the electrode portion 24 acts as a "second connecting portion" according to the invention.

As shown in Fig. 9, the bypass diode 10h of the solar battery cell 2b is connected in parallel with the solar battery cell 2c.

In this embodiment, to the circuit board 3, an external bypass diode 30 is connected in parallel with the solar battery cell 2a. The external bypass diode 30 is an example of a "bypass diode" according to the invention. In Figs. 1 to 3, the external bypass diode 30 is omitted.

In this embodiment, only one external bypass diode 30 is provided for one circuit board 3. The pn junction of the external bypass diode 30 is shielded from light so as not to generate electric power.

The solar battery cells 2 and the circuit board 3 may be electrically connected together by use of an electrically conductive adhesive layer (not shown) such as solder or, as will be described later, by pressing the solar battery cells 2 and the circuit board 3 against each other from above and below by use of sealing members 102 and 104 or the like during assembly into a solar battery module 101. In either case, first, a plurality of solar battery cells 2 are mounted on the circuit board 3, and then, for example through a reflow process or a pressing process using sealing members 102 and 104, the plurality of solar battery cells 2 can be electrically connected to the circuit board 3 at once. This helps shorten the manufacturing time of the solar battery string 1.

In a case where only two solar battery cells 2 are mounted on the circuit board 3, the circuit board 3 need not be provided with the electrode portion 23; only the electrode portions 21, 22, and 24 suffice. In a case where four or more solar battery cells 2 are mounted on the circuit board 3, as many electrode portions 23 as the number of additional solar battery cells 2 need to be provided between the electrode portion 22 and the electrode portion 24.

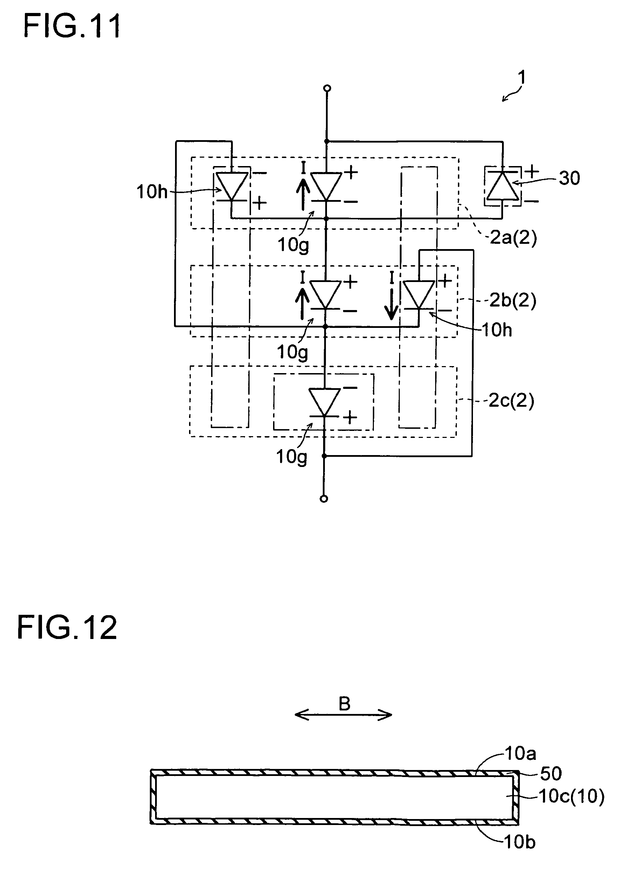

Next, with reference to Figs. 10 and 11, the operation of the solar battery string 1 will be described. In Figs. 10 and 11, the regions enclosed by dash-and-dot lines are regions that are not irradiated by solar light.

As shown in Fig. 10, during the use of the solar battery string 1, when none of the solar battery cells 2 is shaded, electric current (I) passes through the diodes 10g of all the solar battery cells 2. At this time, no electric current (I) passes through the bypass diode 10h or the external bypass diode 30.

By contrast, as shown in Fig. 11, for example, when the solar battery cell 2c is shaded, the solar battery cells 2a and 2b generate electric power and thereby apply a reverse bias voltage to the solar battery cell 2c. This puts the n side (n⁺-type conductivity region 10d) of the diode 10g of the solar battery cell 2c at a positive potential and the p side (p-type conductivity region 10e) thereof at a negative potential, and puts the n side (n⁺-type conductivity region 10d) of the bypass diode 10h of the solar battery cell 2b at a negative potential and the p side (p-type conductivity region 10f) thereof at a positive potential.

Thus, no electric current (I) passes through the diode 10g of the solar battery cell 2c, but electric current (I) passes through the bypass diode 10h of the solar battery cell 2b. That is, electric current (I) passes through the bypass diode 10h and the diode 10g of the solar battery cell 2b and through the diode 10g of the solar battery cell 2a. At this time, no electric current (I) passes through the bypass diode 10h of the solar battery cell 2a or the external bypass diode 30 thereof.

In this way, electric current is bypassed so as not to pass through the shaded solar battery cell 2c, and thereby a rise in the reverse bias voltage is suppressed.

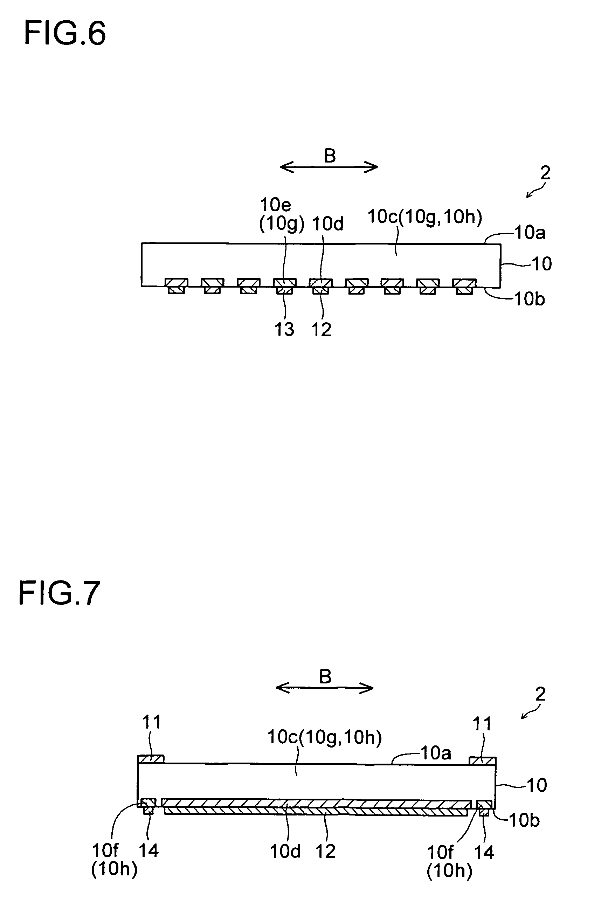

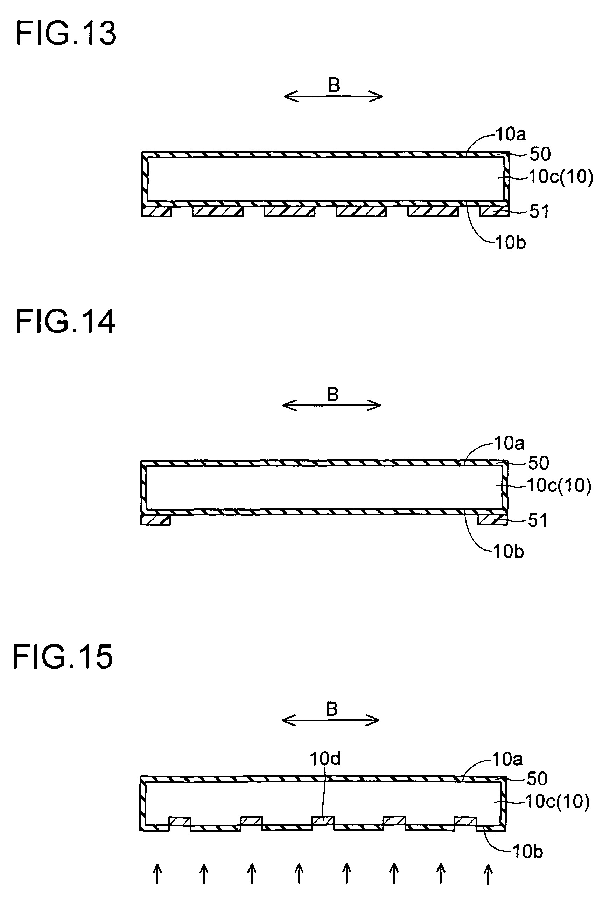

Next, with reference to Figs. 6, 7, and 12 to 22, the manufacturing process of a solar battery cell 2 embodying the invention will be described. Figs. 13, 15, 17, 19, and 21 are sectional views along line 200-200 in Fig. 4, and Figs. 14, 16, 18, 20, and 22 are sectional views along line 250-250 in Fig. 4.

First, as shown in Fig. 12, a semiconductor substrate 10 is prepared which is formed of an n-type silicon substrate and is formed to have a thickness of about 50 µm to about 400 µm. The thickness and material of the semiconductor substrate 10, however, are not limited to those just mentioned.

Then, at least over the entire reverse face 10b of the semiconductor substrate 10, a diffusion prevention mask 50 is formed which is formed of a SiO₂ film or the like to have a thickness of about 300 nm. At this time, the diffusion prevention mask 50 may be formed also over the light-receiving face 10a of the semiconductor substrate 10. The diffusion prevention mask 50 may be formed on the light-receiving face 10a and the reverse face 10b of semiconductor substrate 10 by, for example, a thermal oxidation process.

Thereafter, as shown in Figs. 13 and 14, by a photolithography technology, a photoresist pattern 51 is formed on the reverse face of the diffusion prevention mask 50, under the region other than the region where an n⁺-type conductivity region 10d (see Figs. 6 and 7) will be formed later.

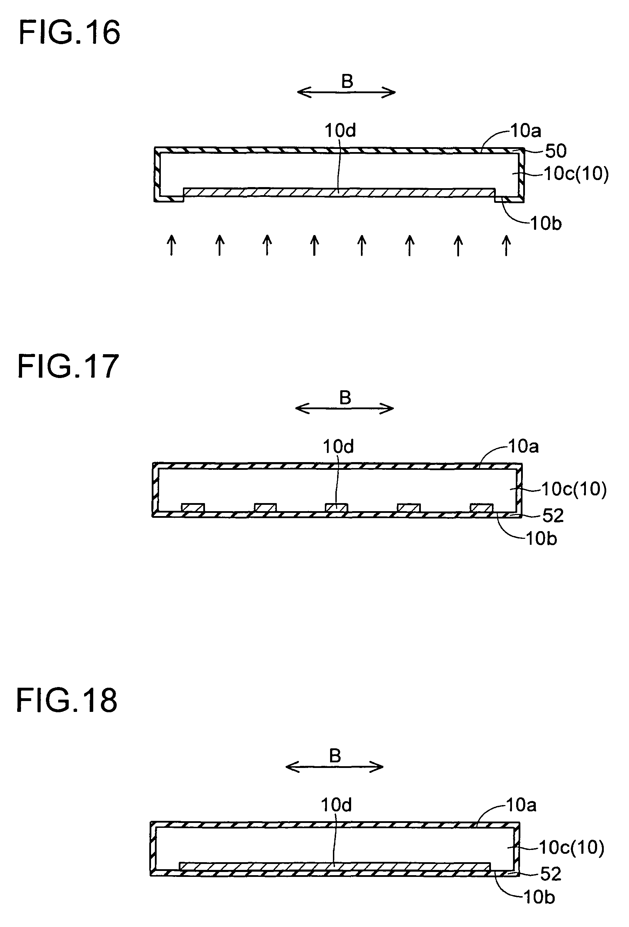

Then, with the photoresist pattern 51 as a mask, etching is performed to remove a predetermined region of the diffusion prevention mask 50. Thus, the reverse face 10b of the region of the semiconductor substrate 10 where the n⁺-type conductivity region 10d will be formed is exposed. Thereafter, as shown in Figs. 15 and 16, the photoresist pattern 51 is removed, and then, through a gas-phase diffusion process performed for about 30 minutes at a temperature of about 770 degrees using as a diffusion source a substance containing, for example, phosphorus as an n-type dopant, such as POCl₃ (phosphorus oxychloride), the n⁺-type conductivity region 10d is formed in the predetermined region on the reverse face 10b side of the semiconductor substrate 10.

Next, the diffusion prevention mask 50 is removed by use of an aqueous solution of hydrogen fluoride, and then, as shown in Figs. 17 and 18, at least over the entire reverse face 10b of the semiconductor substrate 10, a diffusion prevention mask 52 is formed which is formed of a SiO₂ film or the like to have a thickness of about 400 nm. At this time, the diffusion prevention mask 52 may be formed also on the light-receiving face 10a of the semiconductor substrate 10. The diffusion prevention mask 52 may be formed by, for example, a CVD (chemical vapor deposition) process or the like.

The diffusion prevention mask 52 has a function of protecting the n⁺-type conductivity region 10d, and a function of, during the later-described formation of the p-type conductivity regions 10e and 10f, preventing a p-type dopant from diffusing into other than a predetermined region of the semiconductor substrate 10.

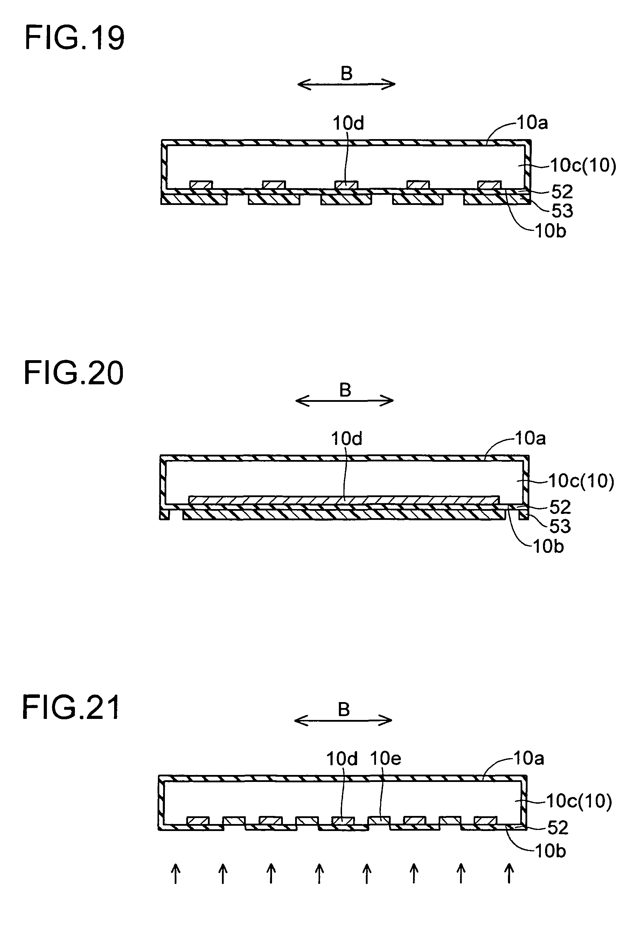

Thsn, as shown in Figs. 19 and 20, by a photolithography technology, a photoresist pattern 53 is formed on the reverse face of the diffusion prevention mask 52, under the region other than the region where p-type conductivity regions 10e and 1 0f (see Figs. 6 and 7) will later be formed.

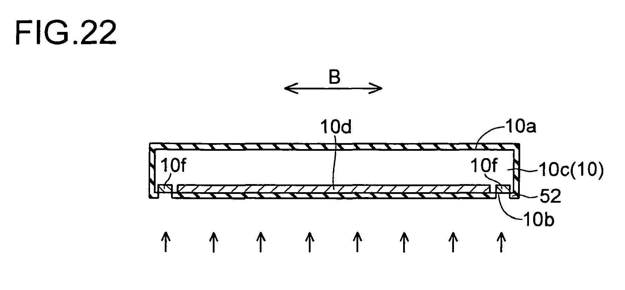

Thereafter, with the photoresist pattern 53 as a mask, etching is performed to remove a predetermined region of the diffusion prevention mask 52. Thus, the reverse face 10b of the region of the semiconductor substrate 10 where the p-type conductivity regions 10e and 1 0f will be formed is exposed. Then, as shown in Figs. 21 and 22, the photoresist pattern 53 is removed, and then, through a gas-phase diffusion process performed for about 50 minutes at a temperature of about 970 degrees using as a diffusion source a substance containing, for example, B (boron) as an a p-type dopant, such as BBr₃ (boron tribromide), the p-type conductivity regions 10e and 10f are formed in the predetermined region on the reverse face 10b of the semiconductor substrate 10.

Thereafter, the diffusion prevention mask 52 is removed, and then, as shown in Figs. 6 and 7, on the n⁺-type conductivity region 10d of the semiconductor substrate 10 and on the p-type conductivity regions 10e and 10f thereof, the n-electrode 12 and the p-electrodes 13 and 14 are formed respectively. The n-electrode 12 and the p-electrodes 13 and 14 can be formed by a photolithography technology, a vacuum deposition process, or the like.

Next, on the light-receiving face 10a of the semiconductor substrate 10, a light-shielding film 11 is formed so as to cover the light-receiving face 10a side of the p-type conductivity region 1 0f.

It is preferable that, on the light-receiving face 10a of the semiconductor substrate 10, a texture structure (not shown) be formed by an etching process using an alkaline aqueous solution such as an aqueous solution of potassium hydroxide. It is preferable that, after the formation of the texture structure, an anti-reflection film (not shown) be formed on the light-receiving face 10a of the semiconductor substrate 10.

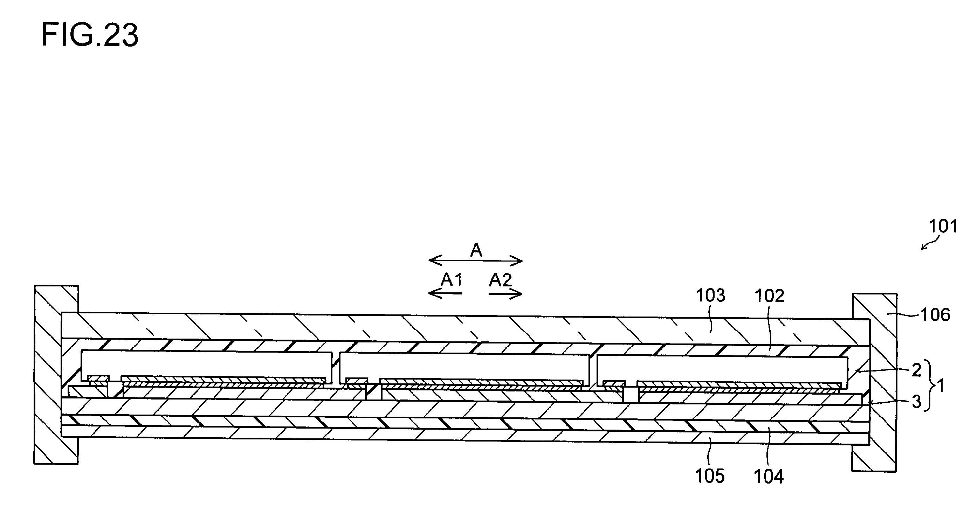

Next, with reference to Fig. 23, the structure of a solar battery module 101 incorporating a solar battery string 1 embodying the invention will be described.

As shown in Fig. 23, the solar battery module 101 incorporating the solar battery string 1 embodying the invention is provided with a solar battery string 1, a sealing member 102 and a transparent substrate 103 which cover the light-receiving face side of the solar battery string 1, a sealing member 104 and a reverse-face film 105 which cover the reverse face side of the solar battery string 1, and a frame member 106 which fixes those components together at their circumference. The solar battery module 101 is fitted with a terminal box (not shown) for extraction of the electric current it generates.

The sealing member 102 is formed of, for example, a resin that is transparent to solar light. For example, the sealing member 102 can be formed of at least one transparent resin selected from the group consisting of ethylene-vinyl acetate resin, epoxy resin, acrylic resin, urethane resin, olefin resin, polyester resin, silicone resin, polystyrene resin, polycarbonate resin, and rubber-based resin. The material for the sealing member 102 is not limited to those just mentioned so long as it is transparent to solar light.

The transparent substrate 103 can be formed of, for example, a glass substrate which is transparent to solar light. The material for the transparent substrate 103, however, is not limited to that so long as it is transparent to solar light.

The sealing member 104 may be formed of the same resin as the sealing member 102, or may be formed of a different material from the sealing member 102, such as a resin that is not transparent to solar light. Although in Fig. 23 the sealing member 102 and the sealing member 104 have no contact with each other, these may be formed integrally by being bonded together.

Usable as the reverse-face film 105 is a sheet material formed of a weather-resistant film as has conventionally been used. It is preferable to use, as a sheet material formed of a weather-resistant film, one having a metal film held between electrically insulating films. Usable as the electrically insulating and metal films are any conventionally known films. For example, as the electrically insulating film, it is possible to use a polyethylene terephthalate film or the like. Using as the metal film a film of metal such as aluminum makes it possible to sufficiently suppress the permeation of moisture and oxygen toward the sealing member 104, and thus to achieve sufficient long-term reliability with the solar battery module 101.

The frame member 106 is formed of, for example, aluminum.

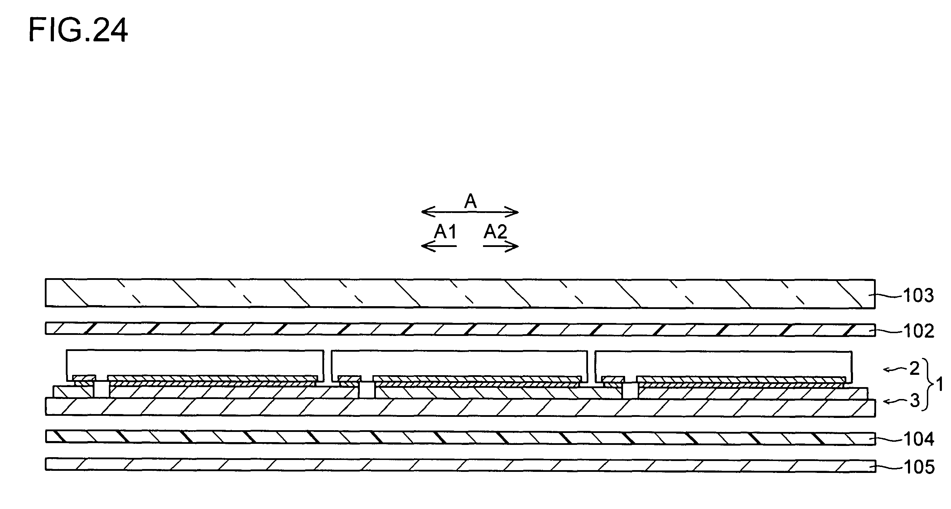

Next, with reference to Figs. 23 and 24, the manufacturing process of the solar battery module 101 embodying the invention will be described.

First, as shown in Fig. 24, the solar battery string 1 is arranged between the sealing member 102 and the sealing member 104. Then the sealing member 102, the solar battery string 1, and the sealing member 104 are arranged between the transparent substrate 103 and the reverse-face film 105.

Thereafter, while the transparent substrate 103 and the reverse-face film 105 are pressed from above and below them, the sealing member 102 and the sealing member 104 and heated to be hardened. Thus, the components from the transparent substrate 103 through the reverse-face film 105 are integrated together.

With the solar battery string 1 placed between the sealing member 102 and the sealing member 104, the solar battery cells 2 and the circuit board 3 may, or may not, be previously fixed together with an electrically conductive adhesive layer such as of solder.

Even in a case where the solar battery cells 2 and the circuit board 3 are not previously fixed together, when the sealing members 102 and 104 are hardened, the pressure resulting from the hardening of the members 102 and 104 causes the solar battery cells 2 and the circuit board 3 to be electrically connected together. Electrically connecting the solar battery cells 2 and the circuit board 3 together in this way without the use of an electrically conductive adhesive layer such as solder helps reduce the number of materials used, and helps simplify the manufacturing process.

Then, as shown in Fig. 23, the circumference of the components from the transparent substrate 103 through the reverse-face film 105 is fitted in the frame member 106, and in this way the solar battery module 101 is fabricated.

In this embodiment, as described above, providing the light-shielding film 11 which covers the light-receiving face 10a side of the p-type conductivity region 10f permits the p-type conductivity region 10f and the n-type conductivity region 10c to form a diode (the bypass diode 10h) that does not contribute to the generation of electric power. Moreover, connecting the bypass diode 10h of the solar battery cell 2a in parallel with the solar battery cell 2b and the bypass diode 10h of the solar battery cell 2b in parallel with the solar battery cell 2c permits, when the solar battery cell 2b or 2c is shaded for some reason, electric current to be bypassed so that no electric current passes through the solar battery cell 2b or 2c. Thus, it is possible to prevent the solar battery cells 2b and 2c from being destroyed by a reverse bias voltage.

As described above, in this embodiment, it is not necessary to externally connect an external bypass diode 30 to every solar battery cell 2. Thus, compared with a case where an external bypass diode 30 is externally connected to every solar battery cell 2, it is possible to shorten the manufacturing time of the solar battery string 1, and to suppress a lowering in the mounting density of the solar battery cells 2 in the solar battery string 1.

In this embodiment, as describe above, the n-type conductivity region 10c and the p-type conductivity region 10e together form the diode 10g that generates electric power when irradiated by solar light. The p-type conductivity region 10f and the n-type conductivity region 10c together form a bypass diode 10h. That is, the n-type conductivity region 10c is shared between the diode 10g and the bypass diode 10h. Thus, compared with a case where the diode 10g and the bypass diode 10h are formed separately, it is possible to shorten the manufacturing time of the solar battery cells 2.

In this embodiment, as describe above, providing the n⁺-type conductivity region 10d and the p-type conductivity regions 10e and 10f on the reverse face 10b side of the semiconductor substrate 10 permits wiring to be done on the reverse face 10b side of the semiconductor substrate 10 alone. This helps simplify the structure of the solar battery string 1, and also helps further shorten the manufacturing time.

As a result of wiring being done on the reverse face 10b side of the semiconductor substrate 10 alone, there is no need to provide a gap between adjacent solar battery cells 2 to pass a lead or the like through. This helps further suppress a lowering in the mounting density of the solar battery cells 2.

Providing the n⁺-type conductivity region 10d and p-type conductivity regions 10e and 1 0f on the reverse face 10b side of the semiconductor substrate 10 eliminates the need to provide an electrode on the light-receiving face 10a of the semiconductor substrate 10 and form it so that part of it reaches the reverse face. This helps further reduce the manufacturing time of the solar battery cells 2.

In this embodiment, as described above, there is no need to provide anything (such as an electrode) other than the light-shielding film 11 on the light-receiving face 10a of the solar battery cells 2, and this helps prevent a lessening of the light-receiving area of the solar battery cells 2. This helps suppress a lowering in the power generation efficiency.

In this embodiment, as described above, providing the p-type conductivity region 10f near an end of the reverse face 10b of the semiconductor substrate 10 makes it easy to prevent, for example, the electrode portion 22 and the electrode portion 23 from crossing each other. Thus, it is possible to prevent the wiring on the circuit board 3 from becoming complicated.

In this embodiment, as described above, each solar battery cell 2 is provided with a plurality of (two) p-type conductivity regions 10f, and this makes it possible to disperse the heat generated when electric current passes through the diode (bypass diode 10h) formed by the p-type conductivity region 10f an the n-type conductivity region 10c. This helps prevent the solar battery cells 2 from becoming hot, and thus helps suppress a lowering in the power generation efficiency of the solar battery cells 2.

In this embodiment, as described above, by connecting the external bypass diode 30 in parallel with the solar battery cell 2a, it is possible to connect a bypass diode 30 or 10h in parallel with every solar battery cell 2. Thus, even when any of the solar battery cells 2 is shaded, it is possible to prevent it from being destroyed.

It should be understood that the embodiment described herein is in every aspect only illustrative and not restrictive. The scope of the present invention is defined not by the foregoing description of the embodiment but by the scope of the appended claims, and encompasses any variations and modifications within the spirit and scope equivalent to those of the claims.

For example, although the embodiment described above deals with a case where the first conductivity type is the n or n⁺ type and the second conductivity type is the p type, this is not meant to limit the invention; the first conductivity type may be the p or p⁺ type and the second conductivity type may be the n type.

Although the embodiment described above deals with a case where a plurality of solar battery cells are connected in series to build a solar battery string, this is not meant to limit the invention; a plurality of solar battery cells may be connected in series and in parallel to build a solar battery string.

Although the embodiment described above deals with a case where a semiconductor substrate formed of a silicon substrate is used, this is not meant to limit the invention; a semiconductor substrate other than a silicon substrate may be used.

Although the embodiment described above deals with a case where the light-shielding film 11 is provided so as to cover the light-receiving face 10a side of the p-type conductivity region 1 0f, this is not meant to limit the invention; no light-shielding film 11 may be provided on the light-receiving face 10a side of the p-type conductivity region 10f.

Although the embodiment described above deals with a case where the solar battery cells are electrically connected together by use of a circuit board, this is not meant to limit the invention; the solar battery cells may be electrically connected together by use of a connecting member other than a circuit board.

Although the embodiment described above deals with a case where the n⁺-type conductivity region 10d and the p-type conductivity regions 10e and 10f are formed by a gas-phase diffusion process, this is not meant to limit the invention; the n⁺-type conductivity region 10d and the p-type conductivity regions 10e and 10f may be formed by an application-diffusion process, or by ion injection of dopant ions. They may also be formed by stacking doped layers on the semiconductor substrate.

Although the embodiment described above deals with a case where POCl₃ containing phosphorus is used as an n-type dopant and BBr₃ containing boron is used as a p-type dopant, this is not meant to limit the invention; any dopants other than POCl₃ and BBr₃ may be used as the n-type and p-type dopants.

Although the embodiment described above deals with a case where a texture structure is formed on the light-receiving face of the semiconductor substrate by use of an alkaline aqueous solution such as an aqueous solution of potassium hydroxide, this is not meant to limit the invention; a texture structure may be formed on the light-receiving face of the semiconductor substrate by use of an acidic aqueous solution or a reactive plasma.

Although the embodiment described above deals with a case where the solar battery module is provided with a frame member, this is not meant to limit the invention; the solar battery module may be provided with no frame member

### List of Reference Signs

- 1: solar battery string
- 2: solar battery cell
- 2a: solar battery cell (first solar battery cell)
- 2b: solar battery cell (first solar battery cell, second solar battery cell)
- 2c: solar battery cell (second solar battery cell)
- 3: circuit board (connecting member)
- 10: semiconductor substrate
- 10a: light-receiving face
- 10b: reverse face
- 10c: n-type conductivity region (first region)
- 10d: n⁺-type conductivity region (second region)
- 10e: p-type conductivity region (third region)
- 10f: p-type conductivity region (fourth region)
- 11: light-shielding film (light-shielding portion)
- 12: n-electrode (first electrode)
- 13: p-electrode (second electrode)
- 14: p-electrode (third electrode)
- 20: base
- 20a: one face (obverse face)
- 22: electrode portion (first connecting portion)
- 23: electrode portion (first connecting portion, second connecting portion)
- 24: electrode portion (second connecting portion)
- 30: external bypass diode
- 101: solar battery module
- 102: sealing member

## Claims

1. A solar battery string, comprising:
a plurality of solar battery cells; and
a connecting member which electrically connects together the plurality of solar battery cells, wherein
the solar battery cells each include:
a semiconductor substrate which has a first region of a first conductivity type;
a second region of a second conductivity type which is provided in a reverse face of the semiconductor substrate and which contains a higher concentration of a dopant than the first region; and
third and fourth regions of a second conductivity type which are provided in the reverse face of the semiconductor substrate,
the plurality of solar battery cells include first and second solar battery cells which are electrically connected together, and
the connecting member includes:
a first connecting portion which electrically connects together the second region of the first solar battery cell and the third region of the second solar battery cell; and
a second connecting portion which electrically connects together the fourth region of the first solar battery cell and the second region of the second solar battery cell.

2. The solar battery string according to claim 1, wherein the connecting member includes:
a base which is electrically insulating; and
the first and second connecting portions which comprise a conductor layer formed on an obverse face of the base.

3. The solar battery string according to claim 1 or 2, wherein the solar battery cells include a light-shielding portion which is formed on a light-receiving face of the semiconductor substrate and which covers a light-receiving face side of the fourth region.

4. The solar battery string according to any one of claims 1 to 3, wherein the fourth region is provided near an end of a reverse face of the semiconductor substrate.

5. The solar battery string according to any one of claims 1 to 4, wherein the solar battery cells each comprise a plurality of fourth regions.

6. The solar battery string according to any one of claims 1 to 5, wherein the second region is arranged between the third and fourth regions.

7. The solar battery string according to any one of claims 1 to 6, wherein first, second, and third electrodes are provided on the second, third, and fourth regions respectively.

8. The solar battery string according to any one of claims 1 to 7, wherein the connecting member is provided with a bypass diode on a one-for-one basis, and the bypass diode is connected in parallel with the first solar battery cell.

9. A solar battery module, comprising:
the solar battery string according to any one of claims 1 to 8; and
a sealing member which seals the solar battery string.

10. A solar battery cell, comprising:
a semiconductor substrate which has a first region of a first conductivity type;
a second region of a second conductivity type which is provided in a reverse face of the semiconductor substrate and which contains a higher concentration of a dopant than the first region; and
third and fourth regions of a second conductivity type which are provided in the reverse face of the semiconductor substrate.

11. The solar battery cell according to claim 10, further comprising a light-shielding portion which is provided on a light-receiving face of the semiconductor substrate and which covers a light-receiving face side of the fourth region.
